# EUROPÄISCHE PATENTANMELDUNG

(11) **EP 4 266 848 A1**
(43) Veröffentlichungstag der Anmeldung: **25.10.2023**
(21) Anmeldenummer: 23020146.9
(22) Anmeldetag: 21.03.2023
(51) Int. Cl.: H05K 7/20

(54) **KÜHLANORDNUNG**

(30) Priorität: 23.03.2022 DE 102022001004
(71) Anmelder: Voss Automotive GmbH, 51688 Wipperfürth (DE)
(72) Erfinder: Englert, Christoph, 51429 Bergisch Gladbach (DE); Kolberg, Ralf, 50733 Köln (DE)
(74) Vertreter: Rebbereh, Cornelia

(57) **Zusammenfassung**

Bei einer Kühlanordnung (1) mit Gehäuse (2) zur Aufnahme zumindest einer wärmeabgebenden elektronischen Komponente (11), insbesondere zumindest einer Leistungselektronikkomponente, und mit Kühlsystem zum Kühlen der zumindest einen wärmeabgebenden elektronischen Komponente (11), wobei die zumindest eine wärmeabgebende elektronische Komponente (11) in dem Gehäuse (2) angeordnet ist, und wobei das Kühlsystem zumindest einen Wärmetauscher umfasst, ist zumindest ein Profilelement (5) aus zumindest einem wärmeleitenden Material als Wärmetauscher vorgesehen und in dem Gehäuse (2) angeordnet, wobei das zumindest eine Profilelement (5) in dem Gehäuse (2) endseitig durch jeweils zumindest ein fixierendes Aufnahmeelement (6, 7) im Gehäuse (2) fixiert ist.

## Beschreibung

Die Erfindung betrifft eine Kühlanordnung mit Gehäuse zur Aufnahme zumindest einer wärmeabgebenden elektronischen Komponente, insbesondere zumindest einer Leistungselektronikkomponente, und mit Kühlsystem zum Kühlen der zumindest einen wärmeabgebenden elektronischen Komponente, wobei die zumindest eine wärmeabgebende elektronische Komponente in dem Gehäuse angeordnet ist, und wobei das Kühlsystem zumindest einen Wärmetauscher umfasst.

Kühlanordnungen mit Gehäuse und Kühlsysteme zum Kühlen wärmeabgebender elektronischer Komponenten sind im Stand der Technik bekannt. Zumeist sind die elektronischen Komponenten in einem Gehäuse integriert, wobei die Kernfunktion des Gehäuses der Schutz der elektronischen Komponenten vor Medien, wie Staub- und Flüssigkeitspartikeln, sowie gegen Stoßbelastungen und gegen zu hohe und zu niedrige Temperaturen ist. Die wärmeabgebenden elektronischen Komponenten sind üblicherweise auf einer Platine angeordnet. Die wärmeabgebenden elektronischen Komponenten sollten eine vorgebbare oder bestimmte Temperatur nicht überschreiten, da sie anderenfalls zerstört werden oder zumindest nicht mehr ordnungsgemäß funktionieren. Zum Einhalten dieser Temperatur ist es bekannt, Wärme von den wärmeabgebenden elektronischen Komponenten abzuführen. Hierzu ist es ebenfalls bekannt, einen Kühlmechanismus einer vorgebbaren bzw. geeigneten Größe vorzusehen. Wenn zumindest ein Teil der elektronischen Komponenten gekühlt werden muss oder sollte, ist es ferner bekannt, das Gehäuse so aufzubauen, dass die Wärmequellen thermischen Kontakt zum Gehäuse haben, das seinerseits von außen, also außerhalb des Gehäuses, vermittels einer oder mehrerer Kühlplatten gekühlt wird. Solche Kühlplatten werden gegebenenfalls von einem Fluid durchströmt, sind also flüssigkeitsgekühlte Kühlplatten.

Aus der DE 10 2018 002 980 A1 ist beispielsweise eine Wärmetauscher-Einheit bekannt, die zumindest ein thermoelektrisches Element, insbesondere ein Peltier-Element, zumindest ein Wärmetauscherelement zum Wärmetausch mit dem thermoelektrischen Element und zumindest ein Verteilerelement zum Zuführen und Abführen eines das zumindest eine Wärmetauscherelement durchströmenden Wärmetauschermediums umfasst, wobei zumindest ein Halterahmen zum Halten des zumindest einen Wärmetauscherelements an dem zumindest einen thermoelektrischen Element vorgesehen ist. Das Verteilerelement ist mit dem Wärmetauscherelement und dem Halterahmen verbunden. Bei diesem Aufbau ist allerdings lediglich ein Halterahmen, kein das thermoelektrische Element vollständig umschließendes Gehäuse vorgesehen, so dass sich dieser Aufbau mit dem Halterahmen bei Umgebungen, bei denen Staub- und Flüssigkeitspartikel vorliegen und dementsprechend sich als problematisch für eine elektronische Komponente auswirken können, nicht eignet.

Aus der EP 3 418 653 A2 ist eine Vorrichtung zum Temperieren eines temperierbaren oder zu temperierenden Volumens, umfassend zumindest eine ein temperierbares Volumen umgrenzende Wandung, bekannt, wobei eine Trennung von Kühl- und Heizfunktion der Vorrichtung zum Temperieren vorgesehen ist. Die zumindest eine Wandung zum Beheizen des zumindest einen temperierbaren oder zu temperierenden Volumens kann beheizt werden. Ferner ist zumindest eine Kühleinrichtung zum Kühlen des temperierbaren Volumens vorgesehen. Die zumindest eine Kühleinrichtung umfasst zumindest ein thermoelektrisches Element und zumindest einen Wärmetauscher zum Abführen von Wärme von dem thermoelektrischen Element. Der Wärmetauscher kann ein Luft-Wärmetauscher oder ein mediumdurchströmter Wärmetauscher sein.

Als nachteilig bei diesen Lösungen des Standes der Technik, bei denen eine Kühlung durch Kühlplatten erfolgt, erweist sich das hohe Gewicht des Gehäuses einerseits und der Kühlplatte andererseits. Ebenfalls erweist sich die ineffiziente Kühlung durch einen hohen thermischen Widerstand zwischen der jeweiligen Wärmequelle und dem Kühlmedium bei Verwendung der mit Wasser durchströmten Kühlplatte als nachteilig.

Der vorliegenden Erfindung liegt daher nun die Aufgabe zugrunde, eine Kühlanordnung mit Gehäuse zur Aufnahme zumindest einer wärmeabgebenden elektronischen Komponente, insbesondere zumindest einer Leistungselektronikkomponente, und mit Kühlsystem zum Kühlen der zumindest einen wärmeabgebenden elektronischen Komponente vorzusehen, wobei die zumindest eine wärmeabgebende elektronische Komponente in dem Gehäuse angeordnet ist und das Kühlsystem zumindest einen Wärmetauscher umfasst, bei der eine effiziente und bauraumoptimierte Kühlung der zumindest einen in dem Gehäuse angeordneten wärmeabgebenden elektronischen Komponente ermöglicht wird.

Die Aufgabe wird für eine Kühlanordnung nach dem Oberbegriff des Anspruchs 1 dadurch gelöst, dass zumindest ein Profilelement aus zumindest einem wärmeleitenden Material als Wärmetauscher vorgesehen und in dem Gehäuse angeordnet ist, wobei das zumindest eine Profilelement in dem Gehäuse endseitig durch jeweils zumindest ein fixierendes Aufnahmeelement im Gehäuse fixiert ist. Weiterbildungen der Erfindung sind in den abhängigen Ansprüchen definiert.

Dadurch wird eine Kühlanordnung geschaffen, bei der durch das Anordnen eines Kühlmechanismus in Form des zumindest einen Profilelements, das als Wärmetauscher ausgebildet und im Gehäuse der Kühlanordnung angeordnet ist oder wird, nahe an der zumindest einen wärmeabgebenden elektronischen Komponente, das Kühlen von dieser bzw. diesen gegenüber den Lösungen des Standes der Technik deutlich verbessert werden kann. Das zumindest eine Profilelement wird hierbei an seinen Enden in dem Gehäuse mechanisch fixiert, um es in seiner Position zu halten. Das zumindest eine Profilelement wird dabei in einem optimalen Abstand bezüglich der zumindest einen wärmeabgebenden elektronischen Komponente bzw. einer Platine, auf der diese angeordnet ist oder sind, positioniert, so dass ein sehr guter Wärmeübergang zum Abführen von Wärme von der zumindest einen wärmeabgebenden elektronischen Komponente und Zuführen von Wärme zu dieser ermöglicht wird. Das Fixieren des zumindest einen Profilelements im Gehäuse könnte grundsätzlich durch Einklemmen des der Kühlung dienenden zumindest einen Profilelements im Bereich seiner Längserstreckung zwischen Klemmelementen im Innern des Gehäuses erfolgen. An der bzw. den Einklemmstellen zwischen den Klemmelementen ginge jedoch Fläche verloren, die zur Kühlung der wärmeabgebenden elektronischen Komponenten zur Verfügung stehen könnte. Anstelle dessen wird erfindungsgemäß daher das zumindest eine Profilelement endseitig mittels der zumindest zwei fixierenden Aufnahmeelemente im Gehäuse mechanisch fixiert. Das zumindest eine Profilelement wird im Bereich seiner Enden in diesen aufgenommen und dabei zugleich positionsfixiert. Hierdurch kann das zusätzlichen Platz erfordernde Einklemmen des zumindest einen Profilelements zwischen Klemmelementen im Innern des Gehäuses vermieden werden. Ferner kann dabei der gesamte Bauraum der Kühlanordnung minimiert werden, da das Anordnen von Klemmelementen im Gehäuse, zwischen denen das Profilelement eingeklemmt wird, und somit der dem Einklemmen des Profilelements dienende zusätzliche Bauraum nicht mehr erforderlich ist. Daher kann der Bauraum im Innern des Gehäuses, den solche Klemmelemente einnehmen würden, nun genutzt werden, um weitere elektronische Komponenten zu kühlen. Bei Beibehalten bzw. Vorsehen eines vergleichsweise größeren als für das Kühlen eigentlich erforderlichen Bauraums können somit mehr wärmeabgebende elektronische Komponenten in diesem angeordnet und gekühlt werden als dies mit den Lösungen des Standes der Technik möglich ist. Der zum Kühlen der wärmeabgebenden elektronischen Komponenten erforderliche Bauraum der Kühlanordnung kann ferner so klein wie möglich, somit kleiner als bei den Lösungen des Standes der Technik, ausgebildet werden, da auf dem jeweiligen Profilelement aufgrund von dessen endseitiger Aufnahme und Fixierung in den fixierenden Aufnahmeelementen mehr Kühlfläche zur Wärmeabfuhr genutzt werden kann, da diese Kühlfläche nicht durch Einklemmen zwischen Klemmelementen verloren geht.

Vorteilhaft umfasst das fixierende Aufnahmeelement zumindest einen Flanschabschnitt, zumindest einen Verbindungsabschnitt und zumindest eine Aufnahmeöffnung zum Aufnehmen des zumindest einen Profilelements, wobei der jeweilige Verbindungsabschnitt zum Verbinden des fixierenden Aufnahmeelements mit Fluidanschlussverbindern zur Zu- und Abfuhr von Kühlmedium zu und von dem Profilelement dient. Das fixierende Aufnahmeelement umfasst somit einerseits einen Flanschabschnitt, in dem die zumindest eine Aufnahmeöffnung angeordnet ist. Diese ist insbesondere schlitzförmig ausgebildet, um darin fixierend das zumindest eine Profilelement aufnehmen und halten zu können. Um eine bauraumoptimierte Anordnung des fixierenden Aufnahmeelements im Gehäuse der Kühlanordnung zu ermöglichen, weist das fixierende Aufnahmeelement ferner zumindest einen Verbindungsabschnitt auf, der mit einem jeweiligen Verbindungsabschnitt eines jeweiligen Fluidanschlussverbinders, über den ein Anschluss an insbesondere eine Kühlmediumleitung zum Zu- und Abführen von Kühlmedium zu und von dem Profilelement der Kühlanordnung ermöglicht wird, vorzunehmen. Der zumindest eine Verbindungsabschnitt kann hierbei zumindest eine umlaufende Wandung aufweisen, die den eigentlichen Verbindungabschnitt bildet. Diese kann insbesondere in den jeweiligen Verbindungabschnitt eines jeweiligen Fluidanschlussverbinders zur Zu- und Abfuhr von Kühlmedium aufgenommen, somit in diesen eingefügt werden. Insbesondere ist hierbei ein formschlüssiges Einfügen des Verbindungsabschnitts des fixierenden Aufnahmeelements in den Verbindungsabschnitts des Fluidanschlussverbinders möglich. Innerhalb der zumindest einen umlaufenden Wandung des zumindest einen Verbindungsabschnitts des fixierenden Aufnahmeelements kann weiter vorteilhaft zumindest ein Dichtelement zum Abdichten gegen einen Kühlmediumaustritt angeordnet sein oder werden. Das zumindest eine Dichtelement kann sich insbesondere sowohl innerhalb des Verbindungsabschnitts des fixierenden Aufnahmeelements als auch innerhalb des Verbindungsabschnitts und/oder eines weiteren Abschnitts des Fluidanschlussverbinders zur Zu- und Abfuhr von Kühlmedium zu und von dem Profilelement erstrecken. Hierdurch ist es möglich, eine vollständige Abdichtung gegenüber einem ungewollten Kühlmediumaustritt aus dem Anschlussverbinder nach außen sicherzustellen.

Zum abdichtenden Durchführen des zumindest einen Profilelements weist das zumindest eine Dichtelement vorteilhaft zumindest eine schlitzförmige Durchgangsöffnung auf. Auch der zumindest eine Flanschabschnitt umfasst vorteilhaft die zumindest eine Aufnahmeöffnung, wobei die zumindest eine Aufnahmeöffnung als schlitzförmige Durchgangsöffnung zum Durchführen und mechanischen Fixieren des zumindest einen Profilelements ausgebildet ist. Dementsprechend erstreckt sich das jeweilige Ende des Profilelements nicht nur durch den Flanschabschnitt des fixierenden Aufnahmeelements im Bereich von dessen schlitzförmiger Durchgangsöffnung bzw. Aufnahmeöffnung, sondern auch durch die entsprechend schlitzförmige Durchgangsöffnung in dem zumindest einen Dichtelement hindurch. Hierdurch wird das Profilelement endseitig nicht nur mechanisch fixiert, sondern auch entsprechend gegen einen Austritt von Kühlmedium im Bereich des jeweiligen Anschlussverbinders nach außen abgedichtet.

Das Gehäuse kann weiter vorteilhaft zumindest zwei Gehäuseteile umfassen, wobei das Gehäuse an zwei einander gegenüberliegenden Enden jeweils zumindest eine Aufnahmeöffnung aufweist. Insbesondere können die zumindest zwei Gehäuseteile an zwei einander gegenüberliegenden Enden jeweils zumindest eine Aussparung aufweisen, wobei die jeweiligen Aussparungen in den Gehäuseteilen nach dem Zusammenfügen der Gehäuseteile zu dem geschlossenen Gehäuse die jeweiligen Aufnahmeöffnungen an den einander gegenüberliegenden Enden des Gehäuses bilden. Die Aufnahmeöffnungen am Gehäuse bzw. die jeweiligen Aussparungen an den Gehäuseteilen dienen zur Aufnahme eines jeweiligen Fluidanschlussverbinders zur Kühlmediumzufuhr zu und Kühlmediumabfuhr von dem zumindest einen Profilelement. Der jeweilige Fluidanschlussverbinder zur Kühlmediumzufuhr zu und -abfuhr von dem zumindest einen Profilelement im Inneren des Gehäuses der Kühlanordnung wird somit in der jeweiligen Aufnahmeöffnung im Gehäuse angeordnet. Dementsprechend sind an zwei einander gegenüberliegenden Enden des Gehäuses insgesamt zwei Fluidanschlussverbinder in der jeweils dort vorgesehenen Aufnahmeöffnung angeordnet. Grundsätzlich ist es auch möglich, mehr als jeweils einen Fluidanschlussverbinder an dem jeweiligen Ende des Gehäuses anzuordnen. Zumeist wird es jedoch ausreichend sein, lediglich einen Fluidanschlussverbinder je Gehäuseende vorzusehen. Der jeweilige Fluidanschlussverbinder kann mit seinem jeweiligen Verbindungsabschnitt in die Aufnahmeöffnung im Gehäuse, dementsprechend die Aussparungen der beispielweise zwei aufeinandergefügten Gehäusehälften, hineinkragen, wobei der Flanschabschnitt des fixierenden Aufnahmeelements zur Aufnahme des Profilelements sich auf der entsprechenden Innenseite des Gehäuses, dessen zumindest eine Aufnahmeöffnung zur Aufnahme des Fluidanschlussverbinders überdeckend, anlegt. Hierbei greift das fixierende Aufnahmeelement mit seinem Verbindungsabschnitt in den Verbindungsabschnitt des Fluidanschlussverbinders hinein. Das fixierende Aufnahmeelement dient somit nicht nur zur mechanischen Positionsfixierung des zumindest einen Profilelements im inneren des Gehäuses, sondern zusätzlich auch der Stabilisierung des jeweiligen Fluidanschlussverbinders, da die jeweiligen Verbindungsabschnitte des fixierenden Aufnahmeelements und des Fluidanschlussverbinders insbesondere form- und/oder stoffschlüssig ineinandergreifen bzw. ineinander angeordnet und aufgenommen sind. Das zumindest eine Dichtelement kann dabei so geformt sein, dass es mit einem Flanschabschnitt sich axial zwischen einem Endabschnitt des Verbindungsabschnitts des fixierenden Aufnahmeelements und auf der Innenseite des Fluidanschlussverbinders abstützt, während es sich radial auf der Innenseite des Verbindungsabschnitts des fixierenden Aufnahmeelements einerseits und auf der Innenseite eines Abschnitts des Fluidanschlussverbinders andererseits abstützt. Somit entsteht eine sehr kompakte bauraumoptimierte Anordnung von Fluidanschlussverbinder und fixierendem Aufnahmeelement zusammen mit dem zumindest einen Dichtelement in der jeweiligen Aufnahmeöffnung des Gehäuses der Kühlanordnung. In dieser Anordnung bzw. diesem Aufnahmesystem aus Fluidanschlussverbinder, fixierendem Aufnahmeelement und Dichtelement(en) kann das zumindest eine Profilelement der Kühlanordnung sehr gut mechanisch fixiert und abgedichtet in der jeweiligen Aufnahmeöffnung des Gehäuses aufgenommen und fixiert werden.

Das zumindest eine Profilelement kann insbesondere ein Aluminiumprofilelement, beispielsweise ein Aluminiumextrusionsprofil, sein. Ferner kann es vorteilhaft eine Anzahl von inneren Strömungskanälen aufweisen, durch die Kühlmedium strömen kann oder strömt. Anstelle von Aluminium kann auch ein anderes gut wärmeleitendes Material für das Profilelement, das als Wärmetauscher dient, vorgesehen werden. Die inneren Strömungskanäle können ferner unterschiedliche Breiten aufweisen. Entsprechendes gilt auch für im Inneren des Profilelements angeordnete Stegbereiche oder Stege, die die Formgebung des Profilelements stabilisieren und zwischen den Strömungskanälen angeordnet sind. Auch bezüglich der Stegbereiche bzw. Stegbreite kann eine anwendungsspezifische Optimierung erfolgen. Bei Ausbilden des zumindest einen Profilelements aus Aluminium bzw. als Aluminiumprofil, insbesondere Aluminiumextrusionprofil, ist bei Durchströmen des als Flüssigkeitswärmetauscher ausgebildeten Profilelements eine sehr gute Kühlung auch bei geringen Volumenströmen möglich, vorallem bei vorteilhaft sehr geringer Wandstärke des Profilelements, da eine große zur Wärmeübertragung zur Verfügung stehende Oberfläche vorgesehen ist.

Je nach Anwendungsfall, beispielsweise im Automotivebereich, bei dem es während der Fahrt eines Fahrzeuges beispielweise zu Erschütterungen kommen kann, ist es möglich, eine zusätzliche klemmende Fixierung des zumindest einen Profilelements in dem zumindest einen fixierenden Aufnahmeelement durch zumindest eine Klemmvorrichtung vorzusehen. Diese kann mit dem fixierenden Aufnahmeelement verbunden, insbesondere zumindest teilweise in dieses eingefügt sein oder werden. Insbesondere wird die zumindest eine Klemmvorrichtung zumindest teilweise in den Flanschabschnitt des fixierenden Aufnahmeelements eingefügt. Ferner kann der Flanschabschnitt auf einer seiner Flächen mit zumindest einer Fixier- und/oder Befestigungseinrichtung versehen sein, mit der die zumindest eine Klemmvorrichtung verbunden werden kann. Beispielsweise ist ein Aufklipsen der zumindest einen Klemmvorrichtung auf den Flanschabschnitt des fixierenden Aufnahmeelements möglich. Um einen Durchtritt des zumindest einen Profilelements durch die zumindest eine Klemmvorrichtung zu ermöglichen, weist die zumindest eine Klemmvorrichtung weiter vorteilhaft zumindest eine schlitzförmige Öffnung auf, durch die hindurch sich das Profilelement erstrecken kann.

Ferner kann zumindest eine Fixiereinrichtung zum Fixieren der zumindest einen Klemmvorrichtung in dem Gehäuse vorgesehen sein. Beispielsweise können stiftartige, an der Klemmvorrichtung angreifende oder in diese eingreifende Fixiereinrichtungen in den Gehäuseteilen angeordnet sein. Die Anordnung der stiftartigen Fixiereinrichtungen kann insbesondere flankierend bzw. benachbart zu der Aufnahmeöffnung an den beiden einander gegenüberliegenden Enden des Gehäuses bzw. den entsprechenden Aussparungen in den Gehäuseteilen, insbesondere Gehäusehälften, vorgesehen sein. Die stiftartigen Fixiereinrichtungen können beispielsweise sowohl in Fixier- und/oder Befestigungseinrichtungen, die an dem Flanschabschnitt des fixierenden Aufnahmeelements angeordnet sind, als auch in eine entsprechende Durchgangsöffnung der zumindest einen Klemmvorrichtung eingreifen und somit nicht nur die zumindest eine Klemmvorrichtung an dem fixierenden Aufnahmeelement und in dem Gehäuse fixieren, sondern zugleich auch das fixierende Aufnahmeelement in seiner Position benachbart zu der Aufnahmeöffnung im Gehäuse fixieren. Dementsprechend kann beispielsweise das zumindest eine Profilelement endseitig zunächst mit der zumindest einen Klemmvorrichtung, dem fixierenden Aufnahmeelement und dem Fluidanschlussverbinder, gegebenenfalls unter Zwischenfügen des zumindest einen Dichtelements, vormontiert und diese vormontierte Einheit aus Profilelement, Klemmvorrichtung(en), fixierenden Aufnahmeelementen und Fluidanschlussverbindern, ggf. Dichtelementen, auf die stiftartigen Fixiereinrichtungen aufgesteckt und in die entsprechende Aussparung im Gehäuseteil eingefügt werden. Der zumindest eine weitere Gehäuseteil wird nachfolgend auf diese vormontierten Komponenten der Kühlanordnung aufgefügt und die Gehäuseteile insbesondere stoffschlüssig miteinander verbunden.

Um das Profielement innerhalb des Gehäuses entlang seiner Längserstreckung durch dieses hindurch abzustützen und somit insbesondere ein Durchbiegen von diesem zu verhindern, kann zumindest eine Abstützeinrichtung zum Abstützen des zumindest einen Profilelements in dem Gehäuse vorgesehen sein. Beispielsweise kann zumindest eine stiftförmige oder stiftförmig zulaufende Abstützeinrichtung vorgesehen und in Richtung des Gehäuseinneren von einer Außenwand des Gehäuses aus vorkragen. Auf der zumindest einen stiftförmigen oder stiftförmig zulaufenden Abstützeinrichtung kann sich das Profilelement abstützen. Beispielweise können mehrere nebeneinander und/oder versetzt zueinander angeordnete Abstützeinrichtungen vorgesehen, beispielsweise mehrere stiftförmige oder stiftförmig zu laufende Abstützeinrichtungen, um das Profilelement über seine gesamte Breite hinweg abstützen zu können. Die zumindest eine Abstützeinrichtung kann insbesondere etwa auf der Hälfte der Längserstreckung des zumindest einen Profilelements durch das Gehäuse der Kühlanordnung hindurch angeordnet sein, somit eine etwa mittige Abstützung des zumindest einen Profilelements innerhalb des Gehäuses, wobei die mittige Abstützung sich auf die Gesamtlänge der Erstreckung des Profilelements im Gehäuse der Kühlanordnung bezieht, vorgesehen sein.

Ferner erweist es sich als vorteilhaft, das zumindest eine Profilelement und/oder das Gehäuse mit zumindest einem Halte- und Abstützelement zu versehen zum Halten zumindest einer Platine mit Abstand zu dem zumindest einen Profilelement. Beispielsweise kann die zumindest eine Platine auf solchen Halte- und Abstützelementen, beispielsweise vier solcher Halte- und Abstützelemente, aufgenommen und lösbar mit diesen verbunden werden, z.B. durch Verschrauben. An oder bzw. auf der Platine können ein oder mehrere wärmegebende elektronische Komponenten angeordnet sein oder werden.

Ferner ist es möglich, zumindest ein Plattenelement an oder auf dem zumindest einen Profilelement anzuordnen zum Reduzieren des Abstands zwischen dem Profilelement und zumindest einer wärmeabgebenden elektronischen Komponente und/oder einer Platine, auf der die zumindest eine wärmeabgebende elektronische Komponente angeordnet ist. Beispielsweise ist es möglich, das zumindest eine Plattenelement mit dem zumindest einen Profilelement stoffschlüssig, insbesondere durch Löten, zu verbinden. Anstelle einer außenseitigen Profilierung zum Annähern des Profilelements an unterschiedlich hohe wärmeabgebende elektronische Komponenten, die auf der Platine angeordnet sind, kann somit vorteilhaft zumindest ein Plattenelement auf dem Profilelement angeordnet werden. Durch eine stoffschlüssige Verbindung zwischen dem zumindest einen Plattenelement und dem zumindest einen Profilelement ist ein problemloser Wärmeübergang von einer wärmeabgebenden elektronischen Komponente auf das Plattenelement und von diesem auf das Profilelement sowie das durch dieses hindurch strömende Kühlmedium möglich.

Das zumindest eine Profilelement und die zumindest eine Platine mit den darauf aufgefügten wärmeabgebenden elektronischen Komponenten können auch miteinander insbesondere lösbar oder unlösbar verbunden werden. Zu diesem Zweck können ein oder mehrere Abstandshalte- und Montageelemente vorgesehen werden, die einerseits randseitig das zumindest eine Profilelement umgreifen und andererseits zumindest eine Verbindungseinrichtung zum insbesondere lösbaren Verbinden mit der Platine aufweisen. Hierdurch kann ein gewünschter Abstand zwischen dem zumindest einen Profilelement und der zumindest einen Platine mit den darauf aufgefügten wärmeabgebenden elektronischen Komponenten eingestellt und eingehalten werden.

Da das zumindest eine Profilelement sich ohne Abstützelement(e) und/oder Platine und Profilelement miteinander verbindende Montagelemente sich ggf. in unerwünschter Form durchbiegen kann, können ferner Versteifungseinrichtungen für das Profilelement vorgesehen und insbesondere in das zumindest eine Profilelement eingefügt werden. Beispielsweise können diese sich innerhalb zumindest eines Strömungskanals im Inneren des zumindest einen Profilelementes erstrecken. Hierbei ist insbesondere die Ausgestaltung des zumindest einen Versteifungselementes in Form eines Versteifungsstabs geeignet, der problemlos in zumindest einen der inneren Strömungskanäle des zumindest einen Profilelements eingefügt werden und dieses somit in Längsrichtung versteifen kann.

Zur näheren Erläuterung der Erfindung werden im Folgenden Ausführungsbeispiele von dieser näher anhand der Zeichnungen beschrieben. Diese zeigen in:
- Figur 1: eine perspektivische Explosionsansicht einer ersten Ausführungsform einer erfindungsgemäßen Kühlanordnung, enthaltend zwei Gehäusehälften, ein Profilelement, zwei fixierende Aufnahmeelemente, zwei Dichtelemente und zwei Fluidanschlussverbinder,
- Figur 2: eine perspektivische Explosionsansicht der Kühlanordnung gemäß Figur 1, wobei deren Komponenten des Profilelements der beiden fixierenden Aufnahmeelemente, der beiden Dichtelemente und der beiden Fluidanschlussverbinder aneinander vormontiert sind zur Aufnahme in und an den beiden Gehäusehälften,
- Figur 3: eine perspektivische Ansicht der Kühlanordnung gemäß Figur 1 und 2, wobei das Gehäuse von dieser durch Aufeinanderfügen der beiden Gehäusehälften geschlossen und die Kühlanordnung fertig montiert ist,
- Figur 4: eine Längsschnittansicht durch die fertig montierte Kühlanordnung gemäß Figur 3,
- Figur 4a: eine Detailschnittansicht der Kühlanordnung gemäß Figur 4 im Bereich von deren einer Seite mit daran an- und eingefügtem Fluidanschlussverbinder, der einen Verbindungsabschnitt des fixierenden Anschlusselements, das Dichtelement sowie das eine Ende des Profilelements aufnimmt,
- Figur 5: eine perspektivische Explosionsansicht einer gegenüber der in Figur 1 gezeigten Ausführungsform der erfindungsgemäßen Kühlanordnung modifizierten zweiten Ausführungsform von dieser, bei der das fixierende Aufnahmeelement zusätzlich mit einer Klemmvorrichtung zum klemmenden Fixieren des Profilelements versehen ist bzw. verbunden werden kann,
- Figur 6: eine Detailschnittansicht eines Endes einer erfindungsgemäßen Kühlanordnung in einer dritten Ausführungsform, wobei in das fixierende Aufnahmeelement eine zweite Ausführungsform einer Klemmvorrichtung zum klemmenden Fixieren des Profilelements in dem fixierenden Aufnahmeelement angeordnet ist,
- Figur 7: eine perspektivische Explosionsansicht eines zweiten Montageschritts der Kühlanordnung gemäß Figur 5, wobei bereits die Komponenten des Profilelements, der Klemmvorrichtung, des fixierenden Aufnahmeelements, des Dichtelements und des Fluidanschlussverbinders fertig vormontiert sind zur weiteren Endmontage dieser Einheit in der unteren Gehäusehälfte des Gehäuses der Kühlanordnung,
- Figur 8: eine perspektivische Ansicht des dritten Montageschritts zur Montage der Kühlanordnung gemäß Figur 5, wobei die Einheit aus Profilelement, Klemmvorrichtung, fixierendem Aufnahmeelement, Dichtelement und Fluidverbinder in der unteren Gehäusehälfte durch Aufstecken auf stiftförmige Fixiereinrichtungen im Innern der Gehäusehälfte montiert ist,
- Figur 9: eine perspektivische Explosionsansicht einer weiteren Ausführungsform einer erfindungsgemäßen Kühlanordnung, wobei im Unterschied zu der Ausführungsform nach Figur 1 innerhalb zumindest der einen Gehäusehälfte stiftförmig zulaufende Abstützeinrichtungen angeordnet sind zum Abstützen des Profilelements in dem Gehäuse,
- Figur 10: eine weitere Explosionsansicht eines erfindungsgemäßen Profilelements mit darauf aufgefügtem Plattenelement und randseitig angeordneten Halte- und Abstützelementen sowie einer Platine, auf der wärmeabgebende elektronische Komponenten angeordnet werden,
- Figur 11: eine Seiten- und teilweise Schnittansicht einer weiteren Ausführungsform eines erfindungsgemäßen Profilelements, das randseitig in Halte- und Abstützelementen aufgenommen ist, wobei an diesen ferner eine Platine mit darauf angeordneter wärmeabgebender elektronischer Komponente befestigt ist,
- Figur 12: eine perspektivische Ansicht der Anordnung aus Halte- und Abstützelementen, in denen das Profilelement gehalten wird, entsprechend Figur 11, jedoch ohne an diesen fixierter Platine,
- Figur 12a: eine Detailansicht der Anordnung gemäß Figur 12 im Bereich der Aufnahme des Profilelements in einem der Halte- und Abstützelemente,
- Figur 13: eine Front- und teilweise Schnittansicht eines erfindungsgemäßen Profilelements mit zwei in dessen Strömungskanälen eingefügten Versteifungsstäben,
- Figur 14: eine Front- und teilweise Schnittansicht eines erfindungsgemäßen Profilelements mit in einem seiner Strömungskanäle angeordnetem Versteifungsstab, und
- Figur 15: eine Front- und teilweise Schnittansicht einer weiteren Ausführungsform eines erfindungsgemäßen Profilelements mit in diesem angeordneter Versteifungseinrichtung.

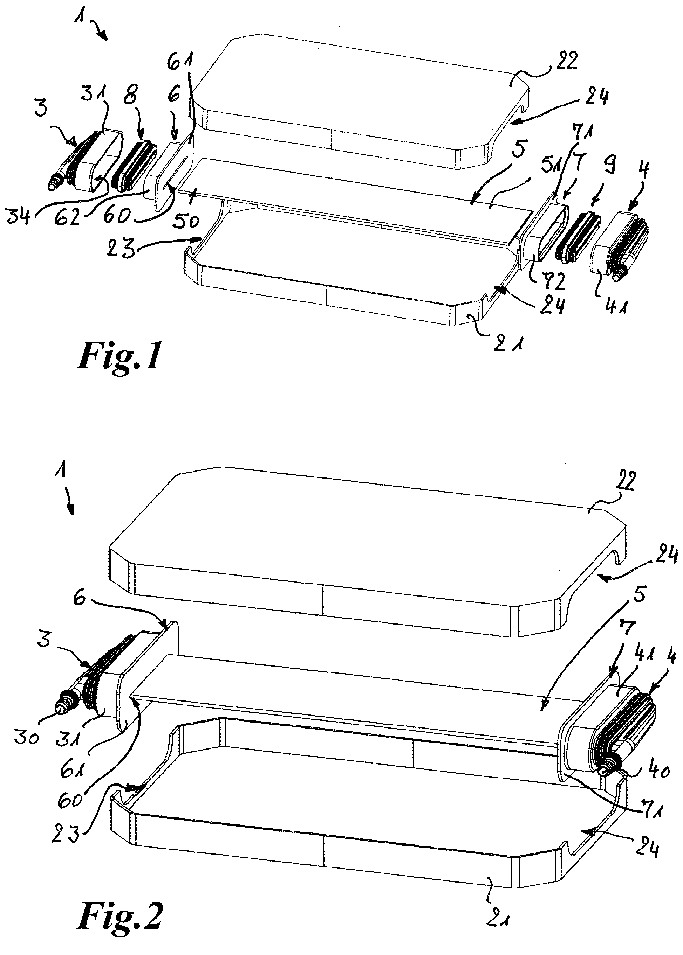

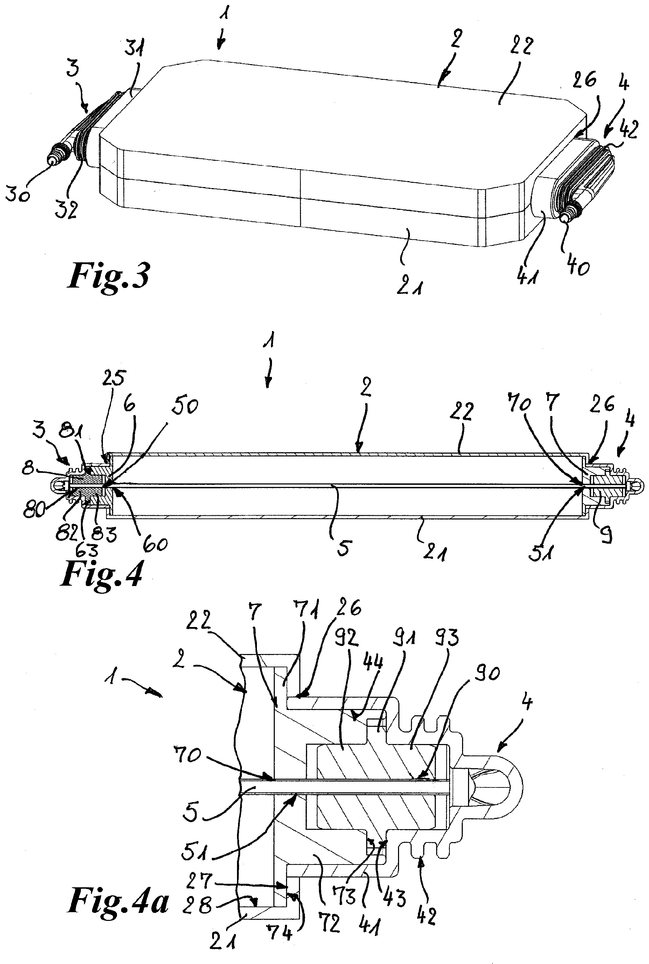

In den Figuren 1 bis 4a ist eine erste Ausführungsform einer Kühlanordnung 1 gezeigt. Diese umfasst ein aus zwei Gehäusehälften 21, 22 gebildetes Gehäuse 2, zwei Fluidanschlussverbinder 3, 4, ein Profilelement 5, zwei fixierende Aufnahmeelemente 6, 7 sowie zwei Dichtelemente 8, 9. Die beiden Gehäusehälften 21, 22 sind in der in den Figuren 1 bis 4a gezeigten Ausführungsform gleichbauend ausgebildet. Sie können jedoch auch als unterschiedlich ausgebildete Gehäuseteile ausgebildet werden. Beide weisen an ihren schmalseitigen Enden jeweils eine Aussparung 23, 24 auf. Diese jeweils bezüglich der beiden Gehäusehälften 21, 22 aneinander gegenüberliegend angeordneten Aussparungen 23, 24 dienen zur Aufnahme eines jeweiligen Verbindungsabschnitts 31, 41 der Fluidanschlussverbinder 3, 4. Die beiden Fluidanschlussverbinderweisen jeweils einen Fluidanschluss 30, 40 und einen Verbindungsabschnitt 31 bzw. 41 auf. Die Verbindungsabschnitte 31, 41 der beiden Fluidanschlussverbinder 3, 4 sind jeweils als umlaufende Wandungen ausgebildet, wie insbesondere Figur 1 besonders gut entnommen werden kann. Mit den jeweiligen Verbindungsabschnitten 31, 41 liegen die beiden Fluidanschlussverbinder 3, 4 in den Aussparungen 23, 24 der beiden Gehäusehälften 21, 22 bzw. den nach dem Zusammenfügen der beiden Gehäusehälften 21, 22 aus deren jeweiligen Aussparungen 23, 24 gebildeten Aufnahmeöffnungen 25, 26 (siehe Figur 4).

Die beiden fixierenden Aufnahmeelemente 6, 7 dienen dem fixierenden Halten der Enden 50, 51 des Profilelementes 5. Zu diesem Zweck weisen die beiden fixierenden Aufnahmeelemente 6, 7 jeweils eine schlitzförmige Durchgangsöffnung 60, 70 auf. Diese erstreckt sich jeweils in einem Flanschabschnitt 61 bzw. 71 der beiden fixierenden Aufnahmeelemente 6, 7. Außer dem jeweiligen Flanschabschnitt 61, 71 weisen die beiden fixierenden Aufnahmeelemente 6, 7 jeweils einen Verbindungsabschnitt 62, 72, der jeweils zum Verbinden der beiden fixierenden Aufnahmeelemente 6, 7 mit den Fluidanschlussverbindern 3, 4 dient. Der jeweilige Verbindungsabschnitt 62, 72 der beiden fixierenden Aufnahmeelemente 6, 7 ist jeweils als umlaufende Wandung ausgebildet, wie ebenfalls besonders gut Figur 1 entnommen werden kann. Die durch die jeweilige schlitzförmige Durchgangsöffnung 60, 70 der beiden fixierenden Aufnahmeelemente 6, 7 hindurch geschobenen und darin aufgenommenen Enden 50, 51 des Profilelements 5 ragen in den jeweiligen Verbindungsabschnitt 62, 72 der beiden fixierenden Aufnahmeelemente 6, 7 hinein bzw. durch diese hindurch, wie den Figuren 4 und 4a besonders gut entnommen werden kann. In den beiden schlitzförmigen Durchgangsöffnungen 60, 70 werden die beiden einander gegenüberliegenden Enden 50, 51 des Profilelements 5 positionsfixiert und gehalten.

Diese beiden Dichtelemente 8, 9 dienen dazu, einen Flüssigkeitsaustritt im Bereich der in die Fluidanschlussverbinder 3, 4 eingefügten fixierenden Aufnahmeelemente 6, 7 zu verhindern. Die beiden Dichtelemente 8, 9 werden dementsprechend einerseits in der jeweiligen umlaufenden Wandung der beiden Verbindungsabschnitte 62, 72 der fixierenden Aufnahmeelemente 6, 7 und andererseits in dem jeweiligen Fluidanschlussverbinder 3, 4 aufgenommen, wie den Figuren 4, 4a entnommen werden kann. Hierbei weisen auch die Dichtelemente 8, 9 jeweils eine schlitzförmige Durchgangsöffnung 80, 90 auf, durch die hindurch sich die Enden 50, 51 des Profilelements 5 erstrecken bzw. erstrecken können. Die beiden Dichtelemente 8, 9 weisen ferner jeweils einen etwa mittig bezüglich ihrer Breitenerstreckung vorkragenden Flanschabschnitt 81, 91 sowie zwei dazu benachbarte Dichtabschnitte 82, 83 bzw. 92, 93 auf. Die beiden Dichtelemente 8, 9 werden, wie am besten den Figuren 4, 4a entnommen werden kann, mit ihrem jeweiligen Dichtabschnitt 83, 92 jeweils in den als umlaufende Wandung ausgebildeten Verbindungsabschnitt 62, 72 der beiden fixierenden Aufnahmeelemente 6, 7 und mit ihrem jeweiligen Dichtabschnitt 82, 93 in einem jeweiligen Übergangsabschnitt 32, 42 der beiden Fluidanschlussverbinder 3, 4 eingefügt. Hierbei sind der jeweilige Außendurchmesser der Dichtelemente 8, 9 im Bereich von deren Dichtabschnitten 82, 83 bzw. 92, 93 jeweils angepasst an den jeweiligen Innendurchmesser einerseits des Verbindungsabschnitte 62, 72 der beiden fixierenden Aufnahmeelemente 6, 7 und andererseits der beiden Übergangsabschnitte 32, 42 der beiden Fluidanschlussverbinder 3, 4. Dementsprechend kann eine radiale Abdichtung des jeweiligen Dichtelements 8, 9 im jeweiligen Verbindungsabschnitt 62, 72 der beiden fixierenden Aufnahmeelemente 6, 7 und im jeweiligen Übergangsabschnitt 32, 42 der beiden Fluidanschlussverbinder 3, 4 erfolgen.

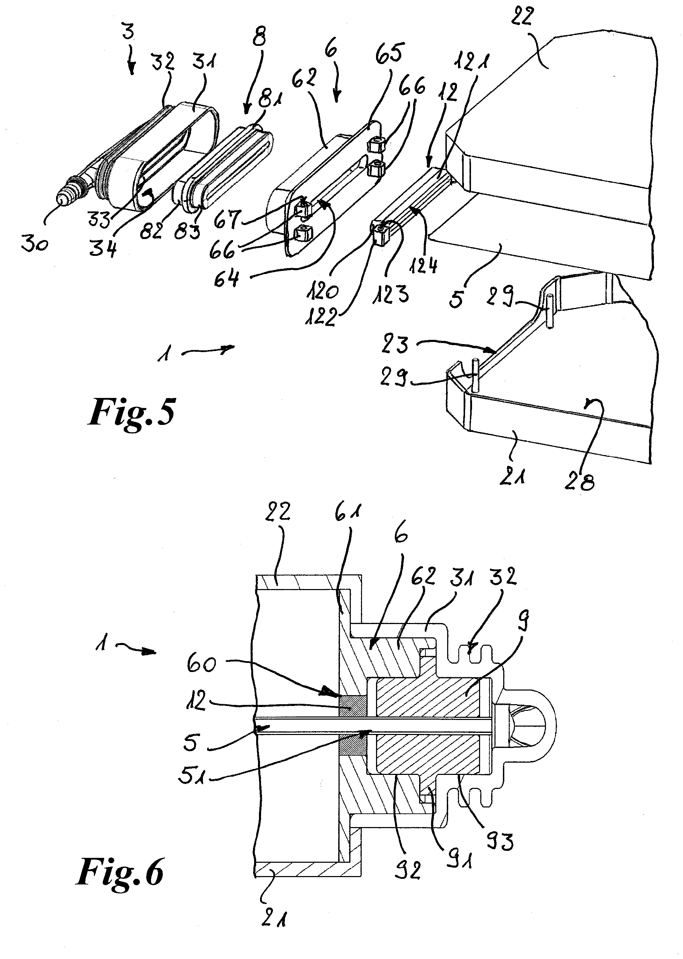

Eine axiale Abdichtung der beiden fixierenden Aufnahmeelemente 6, 7 gegenüber den beiden Fluidanschlussverbindern 3, 4 wird durch den jeweiligen vorkragenden Flanschabschnitt 81, 91 geschaffen, wie ebenfalls insbesondere der Detailansicht der Figur 4a für den Fluidverbinder 4 und den Flanschabschnitt 91 entnommen werden kann. Der jeweilige vorkragende Flanschabschnitt 81, 91 legt sich axial an einer Innenfläche 33 (siehe Figur 5) bzw. 43 der beiden Anschlussverbinder 3, 4 einerseits und andererseits einer jeweiligen axialen Außenfläche 63, 73 der beiden fixierenden Aufnahmeelemente 6, 7 an. Insbesondere wird der jeweilige vorkragende Flanschabschnitt 81 bzw. 91 zwischen diesen Flächen 33, 43 sowie 63, 73 axial eingeklemmt, so dass eine besonders gute Dichtwirkung auch in diesem Bereich erzielt werden kann.

Wie insbesondere der Figur 4a und Figur 5 weiter entnommen werden kann, liegen der jeweilige Verbindungsabschnitt 62, 72 der beiden fixierenden Aufnahmeelemente 6, 7 jeweils formschlüssig auf der jeweiligen Verbindungsabschnittsinnenseite 34 bzw. 44 der beiden Fluidanschlussverbinder 3, 4 an. Der jeweilige Verbindungsabschnitt 31 bzw. 41 der beiden Fluidanschlussverbinder 3, 4 liegt nach dem fertigen Montieren der Kühlanordnung 1 formschlüssig in der jeweiligen Aufnahmeöffnung 25, 26 von deren Gehäuse 2. Die jeweiligen Flanschabschnitte 61, 71 der beiden fixierenden Aufnahmeelemente 6, 7 liegen mit ihren Außenflächen ihrerseits flächig an der jeweiligen Innenseite 27, 28 der beiden Gehäusehälften 21, 22 an, wobei der jeweilige Flanschabschnitt 61, 71 sich somit insbesondere auch an den beiden Gehäusehälften 21, 22 axial abstützt. In Figur 4a ist dies für die Außenfläche 74 des Flanschabschnitts 71 gezeigt. Es wird somit eine kompakte Einheit aus fixierendem Aufnahmeelement 6 bzw. 7 und Fluidanschlussverbinder 3, 4 in Einfügung in der jeweiligen Aufnahmeöffnung 25, 26 des Gehäuses 2 geschaffen. In dieser kompakten Einheit wird das jeweilige Ende 50, 51 des Profilelements 5 aufgenommen, fixiert und gehalten.

Für die Montage der Kühlanordnung 1 kann zunächst das als Wärmetauscher ausgebildete Profilelement 5 an seinen beiden Enden 50, 51 mit den beiden fixierenden Aufnahmeelementen 6, 7 durch deren Aufschieben auf die Enden 50, 51 des Profilelementes 5 verbunden werden. Hierbei weisen die beiden Flanschabschnitte 61, 71 der beiden fixierenden Aufnahmeelemente 6, 7 jeweils in Richtung zueinander, während die beiden Verbindungsabschnitte 62, 72 der fixierenden Aufnahmeelemente 6, 7 jeweils voneinander weg weisen. Nach dem Auffügen der beiden fixierenden Aufnahmeelemente 6, 7 auf die Enden 50, 51 des Profilelementes 5 können die beiden Dichtelemente 8, 9 dort aufgefügt und in die jeweiligen Verbindungsabschnitte 62, 72 der beiden fixierenden Aufnahmeelemente 6, 7 eingefügt werden. Danach können die Fluidanschlussverbinder 3, 4 auf die Dichtelemente 8, 9 und Verbindungsabschnitte 62, 72 der beiden fixierenden Aufnahmeelemente 6, 7, diese übergreifend, aufgefügt werden. Es wird somit eine vorkonfektionierte Baugruppe aus Profilelement 5, fixierenden Aufnahmeelementen 6, 7, Dichtelementen 8, 9 und Fluidanschlussverbindern 3, 4 gebildet. In einem weiteren Montageschritt werden wärmeabgebende elektronische Komponenten 11 in Montage auf zumindest einer Platine 10 benachbart zu dem Profilelement 5 angeordnet, da das Profilelement 5 als Wärmetauscher zur Wärmeabfuhr der von den wärmeabgebenden elektronischen Komponenten abgegebenen Wärme ausgebildet ist. Hierbei können Platinen 10 auch auf beiden Seiten des Profilelements 5, somit auf einander gegenüberliegenden Seiten von diesem, angeordnet werden. Danach erfolgt das Einfügen der vorkonfektionierten Baugruppe und der zumindest einen Platine 10 mit den wärmeabgebenden elektronischen Komponenten 11 in die erste Gehäusehälfte 21. Hierbei liegen die beiden Verbindungsabschnitte 31, 41 der beiden Fluidanschlussverbinder 3, 4 in den beiden einander gegenüberliegenden Aussparungen 23, 24 der ersten Gehäusehälfte 21. Um das Gehäuse 2 zu schließen, wird nachfolgend die zweite Gehäusehälfte 22 auf die erste Gehäusehälfte 21 aufgefügt und insbesondere beide Gehäusehälften miteinander stoffschlüssig verbunden. Die beiden einander gegenüberliegend ausgebildeten Aussparungen 23, 24 nehmen jeweils in sich den Verbindungsabschnitt 31 bzw. den Verbindungsabschnitte 41 der beiden Fluidanschlussverbinder 3, 4 auf.

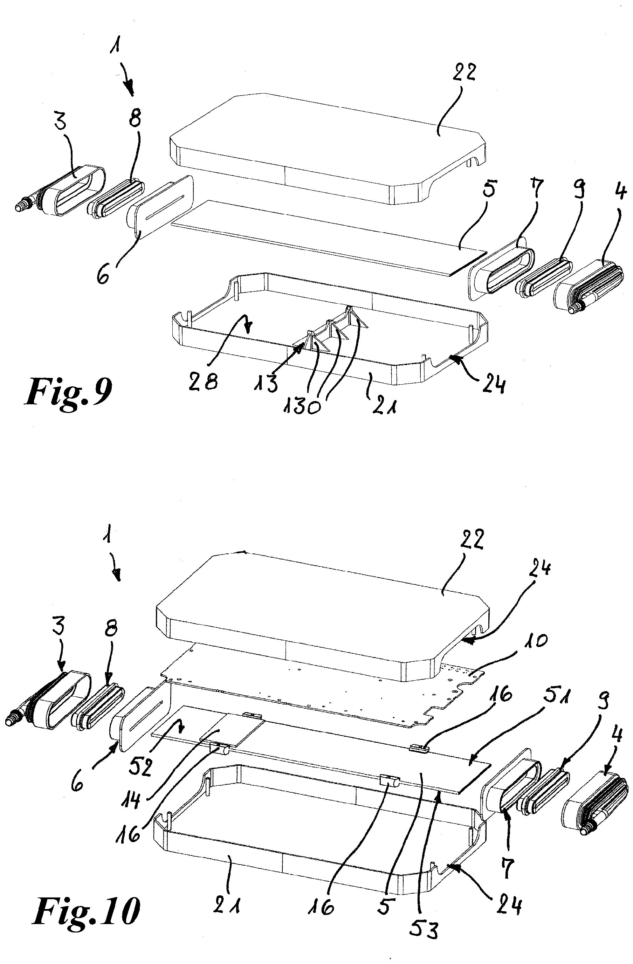

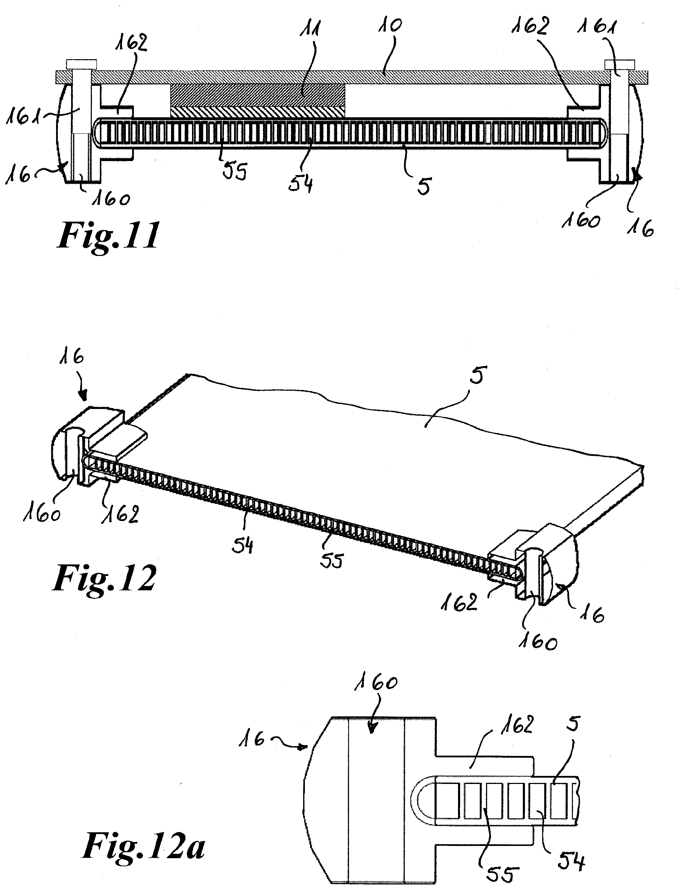

Über die beiden Fluidanschlussverbinder 3, 4 kann insbesondere Kühlmedium dem als Wärmetauscher bzw. Flüssigkeitswärmetauscher ausgebildeten Profilelements 5 zugeführt werden. Das Profilelement 5 weist Strömungskanäle 54 auf, die voneinander durch Stege 55 getrennt sind, wie dies insbesondere den Figuren 11 bis 15 entnommen werden kann. Durch diese Strömungskanäle 54 strömt das über den einen der beiden Fluidanschlussverbinder 3, 4 zugeführte Medium, insbesondere Kühlmedium, durch das Profilelement 5 hindurch und tritt über den anderen der beiden Fluidanschlussverbinder 3, 4 wieder aus der Kühlanordnung 1 aus. Innerhalb des Gehäuses 2 der Kühlanordnung 1 werden nicht nur die vorstehend genannten Komponenten angeordnet, sondern vor allem auch die Platine 10, die mit den wärmeabgebenden elektronischen Komponenten 11 versehen ist, damit die Wärmeabfuhr der von diesen abgegebenen Wärme über das Profilelement 5 erfolgen kann. Eine solche Platine 10 ist beispielhaft in den Figuren 10 und 11 gezeigt, während eine wärmeabgebende elektronische Komponente 11 in Figur 11 angedeutet ist.

Die Figuren 5 bis 8 zeigen eine Variante der Kühlanordnung, wie sie in Figur 1 bis 4 gezeigt ist. Bei dieser Ausführungsvariante ist zusätzlich eine Klemmvorrichtung 12 vorgesehen, die zusätzlich zu dem jeweiligen fixierenden Aufnahmeelement 6, 7 auf die Enden 50, 51 des Profilelements 5 aufgefügt und mit einem Teilabschnitt in das jeweilige fixierende Aufnahmeelement 6, 7 eingefügt wird. In Figur 6 ist eine vereinfachte Ausführungsvariante einer solchen Klemmvorrichtung 12 gezeigt, die vollständig in die schlitzförmige Durchgangsöffnung 70 des fixierenden Aufnahmeelementes 7 eingefügt ist. Durch Vorsehen der Klemmvorrichtung 12 in Aufnahme in der schlitzförmigen Durchgangsöffnung 70 des fixierenden Aufnahmeelementes 7 kann ein noch besserer fixierender Halt des Endes 51 des Profilelementes 5 in diesem gewährleistet werden.

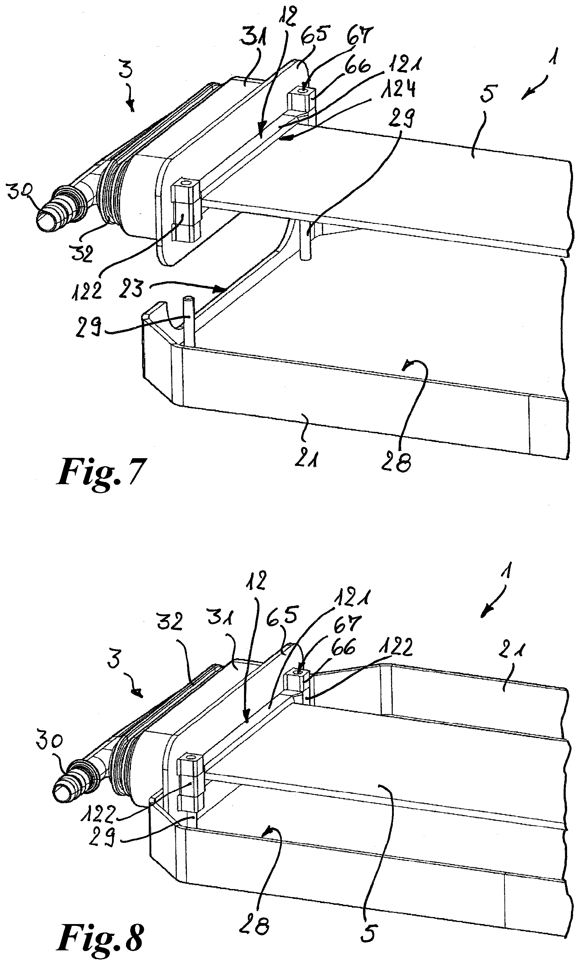

Bei der in den Figuren 5, 7 und 8 gezeigten Ausführungsvariante der Klemmvorrichtung 12 weist diese einen in eine schlitzförmige Durchgangsöffnung 64 eines Flanschabschnitts 65 des fixierenden Aufnahmeelements 6 eingefügten Klemmabschnitt 120 und einen diesem gegenüber größer dimensionierten Halteabschnitt 121 auf. Die Klemmvorrichtung weist durchgehend durch ihren Klemmabschnitt 120 und ihren Halteabschnitt 121 eine schlitzförmige Durchgangsöffnung 124 auf, in der das Profilelement 5 klemmend fixiert gehalten werden kann. Der Flanschabschnitt 65 des fixierenden Aufnahmeelements 6 weist in Richtung weggewandt von dem Verbindungsabschnitt 62 vier Befestigungselemente 66 auf. Entsprechende Befestigungselemente 122 sind auch endseitig an dem Halteabschnitt 121 der Klemmvorrichtung 12 vorgesehen. Alle Befestigungselemente 66, 122 sind jeweils mit einer Durchgangsöffnung 67 bzw. 123 versehen. In zumindest einer der beiden Gehäusehälften 21, 22, hier in Figur 5, 7 und 8 in der Gehäusehälfte 21, sind flankierend zu der jeweiligen Aussparung 23, 24 stiftartige Fixiereinrichtungen 29 angeordnet. Diese dienen dazu, in die jeweiligen Durchgangsöffnungen 67 bzw. 123 der Befestigungselemente 66 bzw. 122 des fixierenden Aufnahmeelementes 6 und der Klemmvorrichtung 12 einzugreifen und diese in ihrer Position zu halten. Die endseitigen Befestigungselemente 122 der Klemmvorrichtung 12 werden jeweils zwischen zwei benachbarte und beabstandete Befestigungselemente 66 am Flanschabschnitt 65 des fixierenden Aufnahmeelements 6 zwischengefügt und nachfolgend die beiden stiftartigen Fixiereinrichtungen 29 durch die dann übereinander fluchtend angeordneten Durchgangsöffnungen 67 und 123 hindurch geschoben, wie in Figur 8 gezeigt.

Figur 9 zeigt eine weitere Ausführungsform der Kühlanordnung 1. Im Unterschied zu der Ausführungsform nach Figur 1 ist hierbei zumindest in der ersten Gehäusehälfte 21 eine Abstützeinrichtung 13 angeordnet. Diese umfasst drei stiftförmig bzw. schmal zulaufende Abstützelemente 130, die benachbart nebeneinander, etwa mittig bezüglich der Längserstreckung der ersten Gehäusehälfte 21 auf deren Innenseite 28 angeordnet sind. Mit ihren Enden ragen die stiftförmig bzw. schmal zulaufenden Abstützelemente 130 somit in Richtung des dort einzufügenden Profilelements 5 und können dieses mittig bezüglich seiner Längserstreckung im Inneren des Gehäuses 2 abstützen. Hierdurch kann verhindert werden, dass das Profilelement 5 sich durchbiegt und insbesondere von den wärmeabgebenden elektronischen Komponenten 11, die möglichst dicht an dem Profilelement 5 im Inneren des Gehäuses 2 angeordnet werden sollen, entfernt. Bei der in Figur 9 gezeigten Ausführungsform der Abstützelemente 130 sind diese untereinander verbunden. Sie können jedoch ebenfalls einzeln nebeneinander oder versetzt zueinander angeordnet sein. Ferner ist in dem gezeigten Ausführungsbeispiel das mittlere Abstützelement 130 endseitig flach, die beiden äußeren Abstützelemente 130 abgeschrägt oder angefast ausgebildet, um das Profilelement 5 besonders gut abstützen zu können.

In Figur 10 ist eine weitere Ausführungsform der Kühlanordnung 1 gezeigt. Hierbei ist zum einen ein Plattenelement 14 auf einem Abschnitt des Profilelements 5 aufgefügt. Das Plattenelement 14 kann zum Reduzieren des Abstands zwischen dem Profilelement 5 bzw. dessen Außenseite 52 und zumindest einer wärmeabgebenden elektronischen Komponente 11, die in Richtung des Profilelements 5 gewandt auf der Platine 10 angeordnet ist, vorgesehen werden. Das Plattenelement 14 kann entweder stoffschlüssig auf die Außenseite 52 des Profilelements 5 aufgefügt sein oder werden oder aufliegend auf dem Profilelement 5 auf dessen Oberfläche fixiert werden.

In Figur 10 sind ferner randseitig an dem Profilelement 5 angreifende Halte- und Abstützelemente 16 gezeigt. Die Halte- und Abstützelemente 16, hier in Figur 10 vier Halte- und Abstützelemente 16, dienen zum Befestigen zumindest einer Platine 10 auf diesen und Einhalten eines vorgebbaren Abstands zwischen Platine 10 und Profilelement 5. Insbesondere können die beiden Halte- und Abstützelemente 16 randseitig auf das Profilelement 5 aufgeschoben werden, somit einen entsprechenden Verbindungsabschnitt aufweisen, der sich auf beiden einander gegenüberliegenden Außenseiten 52, 53 des Profilelements 5 anlegt und somit insbesondere klemmend an dem Profilelement 5 angreift. Ebenfalls ist es möglich, die Halte- und Abstützelemente 16 in anderer Form mit dem Profilelement 5 form- und/oder stoff- und/oder kraftschlüssig zu verbinden. Die Platine 10 wird insbesondere auf die Halte- und Abstützelemente 16 aufgeschraubt.

In den Figuren 11 bis 12a ist eine weitere Ausführungsform der Verbindung von Profilelement 5 und Platine 10 gezeigt, wobei das Profilelement 5 randseitig von den Halte- und Abstützelementen 16 umgriffen wird. Die Halte- und Abstützelemente 16 dienen dazu, eine positionsfixierte Verbindung zwischen dem Profilelement 5 und der Platine 10 mit drauf aufgefügter wärmeabgebender elektronischer Komponente 11 zu schaffen. Zu diesem Zweck weisen die beiden in Figur 11 bis 12a gezeigten Halte- und Abstützelemente 16 jeweils eine sich senkrecht durch diese hindurch erstreckende Nut oder Bohrung 160 auf, in die ein Befestigungselement 161, wie beispielsweise in Form einer Schraube oder eines Niets, eingreift und sich darin festhält. Dies ist Figur 11 besonders gut zu entnehmen. Über diese Befestigungselemente 161 kann die Platine 10 mit den Halte- und Abstützelementen 16 fest oder lösbar verbunden werden, je nach Ausgestaltung des jeweiligen Befestigungselements 161. Das Profilelement 5 wird randseitig in Aufnahmeabschnitte 162 der Halte- und Abstützelemente 16 eingefügt, so dass diese sich an dem Profilelement 5 insbesondere form- und/oder kraftschlüssig festhalten. Durch das Verbinden bzw. Auffügen der zumindest einen Platine 10 an bzw. auf den Halte- und Abstützelementen 16 kann ein fester Abstand zwischen der Platine 10 mit deren zumindest einer wärmeabgebenden elektronischen Komponente 11 und dem Profilelement 5 geschaffen werden. Dies kann Figur 11 ebenfalls entnommen werden.

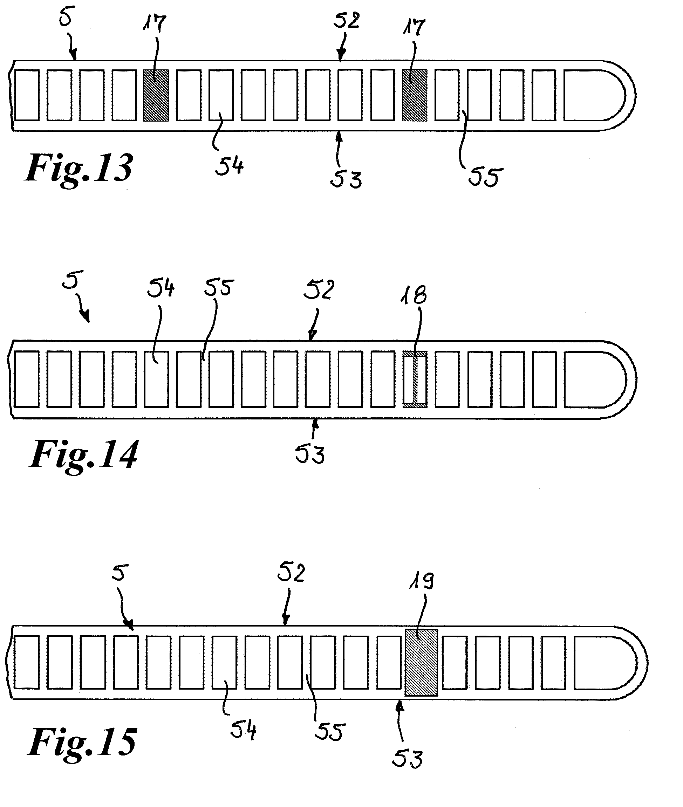

In den Figuren 13 bis 15 ist eine weitere Möglichkeit gezeigt, um das Profilelement 5 in dessen Längserstreckungsrichtung zu versteifen bzw. zu stabilisieren. Zu diesem Zweck sind in Strömungskanälen 54 im Inneren des jeweiligen Profilelementes 5 Versteifungsstäbe 17, 18 bzw. eine Versteigungseinrichtung eingefügt. Die Versteifungsstäbe 17 weisen bei der Ausführungsform nach Figur 13 jeweils ein Rechteckprofil und die Versteifungsstäbe 18 bei der Ausführungsform nach Figur 14 ein Doppel-T-Profil auf. In jedem der Fälle kann ein Versteifen des Profilelementes 5 in dessen Längserstreckungsrichtung hierdurch geschaffen werden. Die jeweiligen Versteifungsstäbe 17, 18 liegen insbesondere formschlüssig in den jeweiligen Durchströmungskanälen 54 des Profilelementes 5.

Bei der Ausführungsform nach Figur 15 ist anstelle eines Versteifungsstabes im Inneren des Profilelements 5 ein Abschnitt nicht als Strömungskanal, sondern als Versteifungsabschnitt 19 ausgebildet. Dieser wird von einem Teil der dort noch vorhandenen Stege 55, die die einzelnen Strömungskanäle im Inneren des Profilelementes 5 voneinander trennen, flankiert. Das Vorsehen solcher Versteifungseinrichtungen, insbesondere in Form von Versteifungsstäben 17, 18 bzw. Versteifungsabschnitten 19 oder in anderweitiger Ausführung, im Inneren des Profilelementes 5 kann insbesondere zusätzlich zu den Abstützeinrichtungen 13 oder anstelle des Vorsehens der Abstützeinrichtungen 13, wie sie in Figur 9 gezeigt ist, zum Stabilisieren der Formgebung des Profilelementes 5 und insbesondere zum Aufrechterhalten eines gewünschten Abstands zur Platine 10 im Inneren des Gehäuses 2 der Kühlanordnung 1 vorgesehen werden.

Neben den im vorstehenden beschriebenen und in den Figuren gezeigten Ausführungsvarianten von Kühlanordnungen können noch zahlreiche weitere gebildet werden, insbesondere auch beliebige Kombinationen der vorstehend genannten Merkmale von dieser, wobei die Kühlanordnung jeweils ein Gehäuse zum Aufnehmen zumindest einer wärmeabgebenden elektronischen Komponente, die insbesondere auf einer Platine angeordnet ist, wie beispielsweise einer oder mehrerer auf einer Platine angeordneter Leistungselektronikkomponenten, und ein Kühlsystem zum Kühlen der zumindest einen wärmeabgebenden elektronischen Komponente aufweist. Die zumindest eine wärmeabgebende elektronische Komponente ist dabei in dem Gehäuse angeordnet. Das Kühlsystem umfasst zumindest ein Profilelement, das als Wärmetauscher ausgebildet ist und aus zumindest einem wärmeleitenden Material besteht. Das Profilelement ist in dem Gehäuse angeordnet und endseitig in diesem durch jeweils zumindest ein fixierendes Aufnahmeelement fixiert und gehalten.

### Bezugszeichenliste

- 1: Kühlanordnung
- 2: Gehäuse
- 3: Fluidanschlussverbinder
- 4: Fluidanschlussverbinder
- 5: Profilelement
- 6: fixierendes Aufnahmeelement
- 7: fixierendes Aufnahmeelement
- 8: Dichtelement
- 9: Dichtelement
- 10: Platine
- 11: wärmeabgebende elektronische Komponente
- 12: Klemmvorrichtung
- 13: Abstützeinrichtung
- 14: Plattenelement
- 16: Halte- und Abstützelement
- 17: Versteifungsstab
- 18: Versteifungsstab
- 19: Versteifungsabschnitt
- 21: erste Gehäusehälfte
- 22: zweite Gehäusehälfte
- 23: Aussparung
- 24: Aussparung
- 25: Aufnahmeöffnung
- 26: Aufnahmeöffnung
- 27: Innenseite
- 28: Innenseite
- 29: stiftartige Fixiereinrichtung
- 30: Fluidanschluss
- 31: Verbindungsabschnitt
- 32: Übergangsabschnitt
- 33: Innenfläche
- 34: Verbindungsabschnittsinnenfläche
- 40: Fluidanschluss
- 41: Verbindungsabschnitt
- 42: Übergangsabschnitt
- 43: Innenfläche
- 44: Verbindungsabschnittsinnenfläche
- 50: erstes Ende
- 51: zweites Ende
- 52: Außenseite
- 53: Außenseite
- 54: Strömungskanal
- 55: Steg
- 60: schlitzförmige Durchgangsöffnung
- 61: Flanschabschnitt
- 62: Verbindungsabschnitt
- 63: axiale Außenfläche
- 64: schlitzförmige Durchgangsöffnung
- 65: Flanschabschnitt
- 66: Befestigungselement
- 67: Durchgangsöffnung
- 70: schlitzförmige Durchgangsöffnung
- 71: Flanschabschnitt
- 72: Verbindungsabschnitt
- 73: axiale Außenfläche
- 74: Außenfläche von 71
- 80: schlitzförmige Durchgangsöffnung
- 81: vorkragender Flanschabschnitt
- 82: Dichtabschnitt
- 83: Dichtabschnitt
- 90: schlitzförmige Durchgangsöffnung
- 91: vorkragender Flanschabschnitt
- 92: Dichtabschnitt
- 93: Dichtabschnitt
- 120: Klemmabschnitt
- 121: Halteabschnitt
- 122: Befestigungselement
- 123: Durchgangsöffnung
- 124: schlitzförmige Durchgangsöffnung
- 130: stiftförmig zulaufendes Abstützelement
- 160: Nut/Bohrung
- 161: Befestigungselement
- 162: Aufnahmeabschnitt

## Patentansprüche

1. Kühlanordnung (1) mit Gehäuse (2) zur Aufnahme zumindest einer wärmeabgebenden elektronischen Komponente (11), insbesondere zumindest einer Leistungselektronikkomponente, und mit Kühlsystem zum Kühlen der zumindest einen wärmeabgebenden elektronischen Komponente (11), wobei die zumindest eine wärmeabgebende elektronische Komponente (11) in dem Gehäuse (2) angeordnet ist, und wobei das Kühlsystem zumindest einen Wärmetauscher umfasst,
**dadurch gekennzeichnet, dass**
zumindest ein Profilelement (5) aus zumindest einem wärmeleitenden Material als Wärmetauscher vorgesehen und in dem Gehäuse (2) angeordnet ist, wobei das zumindest eine Profilelement (5) in dem Gehäuse (2) endseitig durch jeweils zumindest ein fixierendes Aufnahmeelement (6, 7) im Gehäuse (2) fixiert ist.

2. Kühlanordnung (1) nach Anspruch 1,
**dadurch gekennzeichnet, dass**
das fixierende Aufnahmeelement (6, 7) zumindest einen Flanschabschnitt (61, 71), zumindest einen Verbindungsabschnitt (62, 72) und zumindest eine schlitzförmige Öffnung (60, 70) zum Aufnehmen des zumindest einen Profilelements (5) umfasst, wobei der jeweilige Verbindungsabschnitt (62, 72) zum Verbinden des fixierenden Aufnahmeelements (6, 7) mit Fluidanschlussverbindern (3, 4) zur Zu- und Abfuhr von Kühlmedium zu und von dem Profilelement (5) dient.

3. Kühlanordnung (1) nach Anspruch 2,
**dadurch gekennzeichnet, dass**
der zumindest eine Verbindungsabschnitt (62, 72) zumindest eine umlaufende Wandung aufweist.

4. Kühlanordnung (1) nach Anspruch 3,
**dadurch gekennzeichnet, dass**
zumindest ein Dichtelement (8, 9) zum Abdichten gegen einen Kühlmediumaustritt vorgesehen und innerhalb des zumindest einen Verbindungsabschnitts (62, 72) des zumindest einen fixierenden Aufnahmeelements (6, 7) zumindest eines der Dichtelemente (8, 9) zum Abdichten gegen einen Kühlmediumaustritt anordbar oder angeordnet ist.

5. Kühlanordnung (1) nach Anspruch 2, 3 oder 4,
**dadurch gekennzeichnet, dass**
der zumindest eine Flanschabschnitt (61, 71) die zumindest eine schlitzförmige Öffnung (60, 70) umfasst, wobei diese als schlitzförmige Durchgangsöffnung zum Durchführen und mechanischen Fixieren des zumindest einen Profilelements (5) ausgebildet ist.

6. Kühlanordnung (1) nach Anspruch 4 oder 5,
**dadurch gekennzeichnet, dass**
das zumindest eine Dichtelement (8, 9) zumindest eine schlitzförmige Durchgangsöffnung (80, 90) zum abgedichteten Durchführen des zumindest einen Profilelements (5) aufweist.

7. Kühlanordnung (1) nach einem der vorstehenden Ansprüche,
**dadurch gekennzeichnet, dass**
das Gehäuse (2) zumindest zwei Gehäuseteile (21, 22) umfasst, wobei das Gehäuse (2) an zwei einander gegenüberliegenden Enden jeweils zumindest eine Aufnahmeöffnung (25, 26) aufweist, insbesondere die zumindest zwei Gehäuseteile (21, 22) an zwei einander gegenüberliegenden Enden jeweils zumindest eine Aussparung (23, 24) aufweisen, zur Aufnahme eines jeweiligen Fluidanschlussverbinders (3, 4) zur Kühlmediumzufuhr zu und Kühlmediumabfuhr von dem zumindest einen Profilelement (5).

8. Kühlanordnung (1) nach einem der Ansprüche 2 bis 7,
**dadurch gekennzeichnet, dass**
das zumindest eine fixierende Aufnahmeelement (6, 7) sich mit seinem Flanschabschnitt (61, 71) auf der Innenseite (27) des Gehäuses (2) dessen zumindest eine Aufnahmeöffnung (25, 26) zur Aufnahme des Fluidanschlussverbinders (3, 4) überdeckend anlegt, wobei es mit seinem Verbindungsabschnitt (62, 72) in den Verbindungsabschnitt (31, 41) des Fluidanschlussverbinders (3, 4) eingreift.

9. Kühlanordnung (1) nach einem der vorstehenden Ansprüche,
**dadurch gekennzeichnet, dass**
zumindest eine Klemmvorrichtung (12) zum klemmenden Fixieren des zumindest einen Profilelements (5) in dem zumindest einen fixierenden Aufnahmeelement (6, 7) vorgesehen und mit dem fixierenden Aufnahmeelement (6, 7) verbindbar oder verbunden ist, insbesondere zumindest teilweise in dieses einfügbar oder eingefügt ist.

10. Kühlanordnung (1) nach Anspruch 9,
**dadurch gekennzeichnet, dass**
zumindest eine Fixiereinrichtung (29) zum Fixieren der zumindest einen Klemmvorrichtung (12) in dem Gehäuse (2) vorgesehen ist, insbesondere stiftartige an der Klemmvorrichtung (12) angreifende oder in diese eingreifende Fixiereinrichtungen (29) in zumindest einem der Gehäuseteile (21, 22) angeordnet sind.

11. Kühlanordnung (1) nach einem der vorstehenden Ansprüche,
**dadurch gekennzeichnet, dass**
zumindest eine Abstützeinrichtung (13) zum Abstützen des zumindest einen Profilelements (5) in dem Gehäuse (2) vorgesehen ist, insbesondere zumindest eine stiftförmige oder stiftförmig zulaufende Abstützeinrichtung (130) in dem Gehäuse (2) angeordnet ist und in Richtung des Gehäuseinneren vorkragt.

12. Kühlanordnung (1) nach einem der vorstehenden Ansprüche,
**dadurch gekennzeichnet, dass**
das zumindest eine Profilelement (5) und/oder das Gehäuse (2) mit zumindest einem Halte- und Abstützelement (16) versehbar oder versehen ist zum Halten zumindest einer Platine (10) mit Abstand zu dem zumindest einen Profielement (5).

13. Kühlanordnung (1) nach einem der vorstehenden Ansprüche,
**dadurch gekennzeichnet, dass**
zumindest ein Plattenelement (14) an oder auf dem zumindest einen Profilelement (5) anordbar oder angeordnet ist zum Reduzieren des Abstands zwischen dem Profilelement (5) und zumindest einer wärmeabgebenden elektronischen Komponente (11) und/oder einer Platine (10), auf der die zumindest eine wärmeabgebende elektronische Komponente (11) angeordnet ist.

14. Kühlanordnung (1) nach Anspruch 13,
**dadurch gekennzeichnet, dass**
das zumindest eine Plattenelement (14) mit dem zumindest einen Profilelement (5) stoffschlüssig, insbesondere durch Löten, verbindbar oder verbunden ist.

15. Kühlanordnung (1) nach einem der vorstehenden Ansprüche,
**dadurch gekennzeichnet, dass**
das zumindest eine Profilelement (5) ein Aluminiumprofilelement, insbesondere Aluminiumextrusionsprofil, ist und eine Anzahl von inneren Strömungskanälen aufweist, durch die Kühlmedium strömbar ist oder strömt.
